# EUROPÄISCHE PATENTSCHRIFT

(11) **EP 3 616 317 B1**
(45) Veröffentlichungstag und Bekanntmachung des Hinweises auf die Patenterteilung: **20.12.2023**
(21) Anmeldenummer: 18724489.2
(22) Anmeldetag: 27.04.2018
(51) Int. Cl.: H03F 3/187, H03F 3/45, H03F 3/21, H03F 1/30, H03F 3/30, H03F 3/183

(54) **SIGNALVERSTÄRKERSCHALTUNG, SPANNUNGSWANDLER UND SYSTEM**
SIGNAL AMPLIFIER CIRCUIT, VOLTAGE CONVERTER, AND SYSTEM
CIRCUIT D'AMPLIFICATION DE SIGNAL, TRANSFORMATEUR DE TENSION ET SYSTÈME

(30) Priorität: 28.04.2017 DE 102017109213; 28.04.2017 DE 102017109216
(43) Veröffentlichungstag der Anmeldung: 04.03.2020
(60) Teilanmeldung: 23208583.7
(73) Patentinhaber: Burmester Audiosysteme GmbH, 10829 Berlin (DE)
(72) Erfinder: WESTPHAL, Ernst-Heinrich, 10783 Berlin (DE)
(74) Vertreter: Zimmermann & Partner Patentanwälte mbB
(86) Internationale Anmeldenummer: PCT/EP2018/060931
(87) Internationale Veröffentlichungsnummer: WO 2018/197694

(56) Entgegenhaltungen:
- GB-A- 2 064 906
- JP-A- S5 560 316
- US-A- 3 753 137
- US-A- 4 087 761
- US-A- 4 087 761
- US-A- 4 121 168
- US-A1- 2001 050 595
- US-A1- 2012 049 895
- US-A1- 2012 049 895

## Beschreibung

Die Erfindung betrifft eine Signalverstärkerschaltung, insbesondere eine Audioverstärkerschaltung, insbesondere geht es hier um eine Audioendstufenschaltung.

Heutige Signalverstärker sind üblicherweise aus Verstärkertransistoren zusammengesetzt, welche in einer Gegentaktschaltung miteinander verbunden sind. Diese Klasse an Verstärkern wird auch als Class-B-Verstärker bezeichnet. Das Grundprinzip eines solchen Verstärkers besteht darin, dass zwei komplementäre Transistoren an ihren Emittern zusammengeschaltet und mit ihren Kollektoren jeweils an eine positive und eine negative Verstärkerspannungsquelle angeschlossen sind. Ausgehend von einem symmetrischen Signal leitet in diesem Fall jeder der beiden komplementären Transistoren während eines halben Schwingungszyklus. In moderneren Signalverstärkern, insbesondere in Endstufen, in denen große Leistungen erzeugt werden, werden häufig für jeden Schwingungszyklus zwei oder mehr Transistoren bereitgestellt, welche jeweils einen bestimmten Spannungsbereich abdecken. Bei zwei Transistoren pro Schwingungszyklus bedeutet das eine Gegentaktschaltung mit vier Transistoren, wobei jedoch auch Verstärker mit bis zu 12 Transistoren nicht unüblich sind. Die Dokumente GB 2064906 A, US 2012/049895 A1 und US 4087761 A beziehen sich auf

Verstärkerschaltungen. Das Patentdokument JPS5560316 offenbart eine Gegentaktverstärkerschaltung mit Temperaturstabilisierung realisiert mit an die Transistoren der Endstufe thermisch gekoppelten Dioden wobei diese von einer von der Verstärkerspannungsquelle abhängigen Konstantstromquelle gespeist werden.

Werden die Basisanschlüsse der beiden komplementären Transistoren unmittelbar an das Eingangssignal des Verstärkers angeschlossen, dann tritt häufig das Problem der sogenannten Übernahmeverzerrung auf. Grund hierfür ist, dass der zugehörige Transistor nicht leitet, wenn seine Basis-Emitter-Schwellspannung unterschritten wird, weshalb es bei Nullübergängen des Eingangssignals zu der Übernahmeverzerrung kommt. Um Übernahmeverzerrungen zu vermindern oder zu vermeiden, muss sichergestellt werden, dass zu jeder Zeit einer der Transistoren immer leitend ist. Dies wird mittels einer Vorspannung der Basis erreicht. Um hinreichend geringe Übernahmeverzerrungen zu erhalten, besteht die Notwendigkeit, eine ganz bestimmte Vorspannung anzulegen. In Folge dieser Vorspannung stellt sich ein bestimmter Ruhestrom durch die Endstufe ein. Ist dieser Ruhestrom zu gering, dann gibt es um den Nulldurchgang des Ausgangsstromes herum einen Bereich, in dem die Verstärkung der Ausgangsstufe deutlich kleiner ist, als der Wert bei ausreichender Aufsteuerung. Damit entsteht weiterhin eine Übernahmeverzerrung. Ist der Ruhestrom dagegen zu hoch, dann sind im Bereich des Nulldurchgangs beide Zweige der Gegentaktschaltung aktiv. Man erhält dann ebenfalls eine Übernahmeverzerrung, da dann die Verstärkung im Übernahmepunkt deutlich höher ist, als bei "normaler" Aufsteuerung.

Der Temperaturkoeffizient der Basis-Emitter-Schwellspannung des Transistors bzw. der Transistoren ist negativ. Die Vorspannung muss daher mit dem identischen Temperaturkoeffizienten sinken, damit das Verzerrungs-Optimum bei sich ändernder Kühlkörpertemperatur gehalten werden kann. Dies wird üblicherweise mittels Dioden erreicht, nachfolgend Vorspanndioden oder Fühlerdioden genannt, deren Schwellspannung ebenfalls einen negativen Temperaturkoeffizienten hat, der den Temperaturkoeffizienten der Basis-Emitter-Schwellspannung der zugehörigen Transistoren möglichst ähnlich ist. Jedem Transistor ist hierbei eine eigene Vorspanndiode zugeordnet, und mit dieser thermisch gekoppelt. Ist ein Zweig der Gegentaktschaltung aus mehreren Transistoren gebildet, dann wird zu Erzeugung der Vorspannung eine entsprechende Anzahl an zugehörigen Vorspanndioden in einer Diodenkette angeordnet.

Der Ruhestrom des Verstärkers fließt durch die Vorspanndioden, so dass die Vorspannung in ähnlichem Maße wie die Basis-Emitter-Schwellspannung mit steigender Temperatur der Transistoren zurückgeht. Üblicherweise werden die Vorspanndioden von der gleichen Verstärkerspannungsquelle gespeist, welche auch die Verstärkertransistoren versorgt. Hierzu wird parallel zu den Vorspanndioden ein Potentiometer angeordnet, welcher den "Offsetwert" der Vorspannung auf möglichst geringe Verzerrungen bei einer mittleren zu erwartenden Arbeitstemperatur des Verstärkers einstellt. Dieser "Offsetwert" hängt jedoch vom Ruhestrom durch die spannungsverstärkende Stufe des Verstärkers ab, welcher in der Praxis stark temperaturabhängig ist, vor allem dann, wenn man den Verstärker nach dem Kriterium der Schnelligkeit hin optimieren will, was insbesondere bei Audioverstärkern wichtig ist. Damit ergibt sich eine ungewollte Schwankung der Vorspannung, was wiederum zu Verzerrungen am Verstärkerausgang führen kann.

Es ist Aufgabe der Erfindung, eine Signalverstärkerschaltung bereitzustellen, welche ein Signal mit geringerer Verzerrung verstärken kann.

Die Aufgabe wird gemäß der Erfindung durch eine Signalverstärkerschaltung mit den Merkmalen des Anspruchs 1 gelöst. Vorteilhafte Weiterbildungen der Erfindung sind in den Unteransprüchen aufgeführt.

Die Erfindung beruht auf der Überlegung, den Vorspanndioden einen möglichst präzisen Strom zur Verfügung zu stellen, welcher möglichst exakt reproduzierbar und von der Temperatur unabhängig ist. Dies wird erfindungsgemäß dadurch erreicht, dass die Vorspanndioden zumindest teilweise mittels einer von der Verstärkerspannungsquelle unabhängige Spannungsquelle gespeist werden. Eine von der Verstärkerspannungsquelle unabhängige Spannungsquelle zum Versorgen der Vorspanndioden bzw. einer Vorspannschaltung hat den Vorteil, dass die Verstärkerschaltung unabhängig von Erfordernissen der vorgeschalteten Spannungsverstärkerstufe dimensioniert werden kann. Von der Verstärkerspannungsquelle unabhängig kann insbesondere bedeuten, dass die Spannungsquelle von der Verstärkerspannungsquelle galvanisch getrennt ist. Insbesondere erhält die Spannungsquelle ihre Energie nicht direkt oder indirekt von der Verstärkerspannungsquelle.

Eine Möglichkeit der Verwirklichung einer solchen Spannungsquelle ist der Einsatz einer Batterie zur Versorgung der Vorspanndioden. Vorzugsweise handelt es sich bei der Spannungsquelle jedoch um eine Dauerspannungsquelle.

Das bedeutet insbesondere, dass sich die Spannungsquelle nicht entlädt und somit auch nicht regelmäßig geladen oder ersetzt werden muss. Eine derartige Spannungsquelle kann beispielsweise realisiert werden, indem eine Solarzelle mit einer konstanten Lichtquelle kombiniert wird, beispielsweise mit einem oder mehreren LEDs. Vorzugsweise wird hierzu in einem gemeinsamen Gehäuse eine Solarzelle einem LED-Feld gegenübergestellt. Der LED/Solarzellen-Übergang bildet dann eine galvanische Trennung. Zudem bildet der LED/Solarzellen-Übergang keine oder nur sehr geringe Koppelkapazitäten aus. Alternativ oder zusätzlich hierzu kann die Spannungsquelle zur galvanischen Trennung zumindest einen Transformator aufweisen.

Bei einer bevorzugten Ausführungsform ist vorgesehen, dass die unabhängige Spannungsquelle in Bezug auf die Verstärkungstransistoren als potentialfreie Spannungsquelle ausgebildet ist. Das bedeutet insbesondere, dass die Spannungsquelle keinen Nebenschluss vom Ausgang der Spannungsverstärkerschaltung nach Masse darstellt. Anders ausgedrückt, bildet die Spannungsquelle keinen zusätzlichen oder weiteren Verbindungsweg zwischen der Spannungsverstärkerschaltung und der Masse der Spannungsverstärkerschaltung bzw. der Signalmasse. Vorzugsweise wird der Strom für die Vorspanndioden und dem Vorspannwiderstand nicht aus der Verstärkerspannungsquelle gezogen, oder in dem gleichen Maße gezogen, wie wieder symmetrisch zurückgeführt. Der Vorspannstrom durch die Vorspanndioden wird also eingeprägt, ohne den Signalstrom zu beeinflussen.

Die Spannungsquelle sollte zudem vorzugsweise keine oder eine nur sehr geringe Koppelkapazität zur Erde haben, da sie (im Common Mode) mit einer Signalfrequenz des zu verstärkenden Signals "mitläuft" und die Koppelkapazität dieser Spannungsquelle den hochohmigen Signalausgang der Verstärkerschaltung belastet. Weiterhin sollte die Spannungsquelle vorzugsweise keine oder nur eine vernachlässigbare Common-Mode-Störspannung aufweisen, da diese Störspannung ansonsten an dem hochohmigen Signalausgang der Verstärkerschaltung in den Signalweg eingespeist wird.

In einer vorteilhaften Weiterbildung ist vorgesehen, dass die Vorspanndioden mittels der unabhängigen Spannungsquelle über einen Vorspannverstärker gespeist werden. Beispielsweise kann es sich hierbei um einen Gleichspannungsverstärker, insbesondere um einen Präzisions-Gleichspannungsverstärker handeln, welcher beispielsweise mit einem Operationsverstärker zusammengesetzt ist. Üblicherweise unterscheiden sich die Temperaturkoeffizienten der Verstärkungstransistoren und der zugehörigen Vorspanndioden um einen bestimmten Faktor, der üblicherweise etwa 1,2 ist. Somit ist es von Vorteil, wenn die über den Vorspanndioden abfallende Spannung mit diesem Faktor multipliziert wird. Die Verstärkung des Vorspannverstärkers ist vorzugsweise von der Temperatur unabhängig.

Bei einer zweckmäßigen Ausführungsform ist vorgesehen, dass die unabhängige Spannungsquelle und/oder der Vorspannverstärker Teil einer die Vorspanndioden speisenden Konstantstromquelle sind/ist, insbesondere einer Präzisions-Konstantstromquelle. Die Konstantstromquelle ist also aus der Spannungsquelle und/oder dem Vorspannverstärker und gegebenenfalls weiteren elektronischen Komponenten zusammengesetzt. Damit ist der durch die Vorspanndioden fließende Konstantstrom immer exakt reproduzierbar und von der Temperatur unabhängig.

Gemäß einer bevorzugten Weiterbildung ist vorgesehen, dass die Konstantstromquelle einstellbar ausgebildet ist. Hierdurch ist es möglich, den "Offset" der Vorspannung mittels Verändern des von der Präzisions-Konstantstromquelle bereitgestellten Konstantstromes auf geringste Verzerrungen der Verstärkerschaltung einzustellen. Die Flussspannung über einer Diode steigt mit dem Strom und sinkt mit der Temperatur. Der Temperaturkoeffizient der Flussspannung ist jedoch vom Strom praktisch unabhängig.

Bei einer bevorzugten Ausführungsform ist vorgesehen, dass die Vorspanndioden jeweils mit dem zugehörigen Verstärkertransistor in einem gemeinsamen Gehäuse angeordnet sind oder dass die Vorspanndioden jeweils an einem Kühlkörper des zugehörigen Verstärkertransistors angeordnet sind. Vorzugsweise ist für jeden Verstärkertransistor eine thermisch eng gekoppelte Vorspanndiode vorgesehen, um ein exaktes Abbild der Chiptemperaturen der Verstärkertransistoren als zu bekommen. Während die Integration einer Diode im Gehäuse des Verstärkertransistors den Vorteil einer besonders engen thermischen Kopplung mit sich bringt, hat sie andererseits den Nachteil, dass die Vorspanndiode nicht frei ausgewählt werden kann. Es obliegt dann der Vorspannschaltung, die zwischen der Vorspanndiode und dem Verstärkertransistor vorliegenden unterschiedlichen elektronischen Eigenschaften auszugleichen.

Der oder die Verstärkertransistor(en) sind vorzugsweise als Bipolartransistor(en) ausgebildet.

In einer vorteilhaften Weiterbildung ist vorgesehen, dass der zumindest eine erste Verstärkertransistor mehrere in einer ersten Darlingtonschaltung miteinander verbundene erste Verstärkertransistoren umfasst und/oder dass der zumindest eine zweite Verstärkertransistor mehrere in einer zweiten Darlingtonschaltung miteinander verbundene zweite Verstärkertransistoren umfasst. In einer Darlingtonschaltung können zwei, drei oder mehr Verstärkertransistoren verbunden sein und wie ein einziger Verstärkertransistor wirken, jedoch mit einem wesentlich höheren (Strom-)Verstärkungsfaktor.

Bei einer zweckmäßigen Ausführungsform ist die Signalverstärkerschaltung als eine Audioverstärkerschaltung, insbesondere als eine Audioendstufenschaltung ausgebildet. Bei dem mittels der Signalverstärkerschaltung verstärkten Signal handelt es sich also um ein Audiosignal. Eine Audioendstufenschaltung bedeutet insbesondere, dass der Signalverstärkerschaltung eine Eingangsverstärkerstufe vorgeschaltet ist.

Gemäß einer bevorzugten Weiterbildung ist vorgesehen, dass die unabhängige Spannungsquelle einen eingangsseitigen ersten Transformator mit einer ersten Primärwicklung und einer ersten Sekundärwicklung und einen mit dem ersten Transformator verbundenen ausgangsseitigen zweiten Transformator mit einer zweiten Primärwicklung und einer zweiten Sekundärwicklung aufweist, wobei die erste Sekundärwicklung des ersten Transformators unmittelbar mit der zweiten Primärwicklung des zweiten Transformator verbunden ist. Das bedeutet, die Sekundärwicklung bzw. Sekundärspule des ersten Transformators ist unmittelbar mit der Primärwicklung bzw. Primärspule des zweiten Transformators verbunden. Dass die erste Sekundärwicklung des ersten Transformators mit der zweiten Primärwicklung des zweiten Transformators verbunden ist bedeutet insbesondere, dass eine elektrische Verbindung zwischen den beiden Wicklungen vorliegt, dass also die beiden Transformatoren hintereinander geschaltet sind. Vorzugsweise ist die erste Sekundärwicklung des ersten Transformators unmittelbar mit der zweiten Primärwicklung des zweiten Transformators verbunden. Das bedeutet insbesondere, dass der in der ersten Sekundärwicklung erzeugte Strom die zweite Primärwicklung durchfließt, ohne dass das Stromprofil wesentlich geändert wird. Bevorzugt sind zwischen der ersten Sekundärwicklung und der zweiten Primärwicklung in diesem Fall höchstens lediglich rein ohmsche Elemente, beispielsweise ein ohmscher Widerstand oder ein oder mehrere Leitungsstücke angeordnet.

Der zwischen der zweiten Sekundärwicklung und den Ausgangsanschlüssen angeordnete Gleichrichter weist vorzugsweise eine Diodenbrücke auf, um die an der zweiten Sekundärwicklung vorliegende Wechselspannung gleichzurichten. Anschließend kann das gleichgerichtete Signal vorzugsweise mittels weiterer Schaltungen von Oberwellen befreit werden. Insbesondere ist hier der Einsatz einer Serienspule bzw. Seriendrossel vorteilhaft, gegebenenfalls in Zusammenschaltung mit einem Ausgangskondensator als Tiefpassschaltung. Alternativ oder zusätzlich kann jede Diode des Gleichrichters mit einer Parallelschaltung von RC-Serienschaltungen (sogenannte Snubber) versehen sein. Hierdurch werden Oszillationen beim Sperrübergang der Dioden vermieden.

An seinen Eingangsanschlüssen muss die Spannungsquelle mit einer Primärwechselspannung versorgt werden. Die Frequenz der Primärwechselspannung, nachfolgend "Primärfrequenz", liegt vorzugsweise in einem Bereich zwischen 10kHz und 1 MHz, vorzugsweise zwischen 20 kHz und 500 kHz. Vorzugsweise hat die Primärwechselspannung eine Primärfrequenz von mehr als 20 kHz, 25 kHz, 30 kHz, 35 kHz oder 40 kHz. Die Primärwechselspannung kann beispielsweise mittels Umformung einer Gleichspannung in eine höherfrequente Wechselspannung erzeugt werden. Diese Umformung kann mittels elektronischen Leistungsschaltern oder mittels Oszillatoren und linearen Verstärkern erfolgen. Elektronische Leistungsschalter erzeugen hierbei eine Rechteck-Ansteuerung, was insbesondere für eine hohe Effizienz sorgt. Oszillatoren und lineare Verstärker sind hingegen für eine Sinus-Ansteuerung geeignet, welche den geringsten Störpegel liefert. Weiterhin ist bei Verwendung von Rechteckspannungen möglich, diese mit LC-Filtern "abzurunden", so dass man bei immer noch sehr guter Effizienz einen weiter reduzierten Störpegel erzielt.

Die Primärfrequenz ist vorzugsweise so gewählt, dass die Primärwechselspannung keine zusätzlichen Spannungskomponenten in dem verstärkten Signal erzeugt, beispielsweise aufgrund von Koppeleffekten. Handelt es sich bei dem Signalverstärker um einen Audioverstärker, dann liegt die Primärfrequenz vorzugsweise zwischen, aber bevorzugt fernab von, einer Audiobandgrenze von etwa 20 kHz und der Grenzfrequenz des Audioverstärker, welche üblicherweise einige hundert kHz beträgt. Je weiter die Primärfrequenz von der Verstärker-Grenzfrequenz entfernt liegt, desto effektiver werden mögliche Primärwechselspannungs-Störungen aufgrund der Gegenkopplung im Verstärker unterdrückt. Beispielsweise wäre bei einer Verstärker-Grenzfrequenz von 500 kHz eine Primärfrequenz von etwa 100 kHz angebracht. Der Abstand zur Audiobandgrenze betrüge dann 80 kHz und der Abstand zur Verstärker-Grenzfrequenz 400 kHz.

Vorzugsweise weist der erste Transformator einen ersten Kern auf, welcher von einem zweiten Kern des zweiten Transformators getrennt ist, so dass der magnetische Fluss des ersten Kerns den zweiten Kern im Wesentlichen nicht durchströmt.

In einer vorteilhaften Weiterbildung ist vorgesehen, dass die erste Sekundärwicklung und/oder die zweite Primärwicklung maximal fünf Windungen, vorzugsweise maximal drei Windungen, bevorzugt maximal eine Windung aufweist/aufweisen. Vorzugsweise werden die erste Sekundärwicklung und die zweite Primärwicklung durch eine Kurzschlusswindung gebildet, welche beide Kerne der zwei Transformatoren durchdringt. Die Kurzschlusswindung kann hierbei einen Kreis um jeweils einen Schenkel der beiden Kerne bilden, oder sich achtförmig zwischen diesen beiden Schenkeln kreuzen. Eine geringe Anzahl an Windungen oder sogar eine solche Kurzschlusswindung reduziert die oben beschriebene kapazitive Kopplung erheblich, weil die Energieübertragung vom ersten Transformator zu dem zweiten Transformator mittels eines hohen Stroms bei gleichzeitig sehr geringer Spannung erfolgt. Sowohl aufgrund der geringeren Spannung als auch aufgrund der geringeren Koppelkapazität von nur einer oder wenigen Windungen wird die kapazitive Kopplung zwischen der ersten Primärwicklung und der zweiten Sekundärwicklung erheblich reduziert.

Die Verbindungsleitungen zwischen den beiden Transformatoren oder die Kurzschlusswindung können/kann vorteilhafterweise zusätzlich mittels Verdrillen induktionsarm ausgeführt sein. Auf diese Weise ist es möglich, den Abstand zwischen den beiden Transformatoren bzw. zwischen den beiden Kernen weiter zu vergrößern, was die kapazitive Kopplung zusätzlich reduziert.

Bevorzugterweise werden die Verbindungsleitungen zwischen den beiden Transformatoren oder wird die Kurzschlusswindung durch ein Rohr oder ein Ring aus Ferritmaterial hindurch geführt, welches/welcher sich von einem Kern des ersten Transformators zu einem Kern des zweiten Transformators erstreckt, falls diese Kerne vorhanden sind. Hierbei darf das Rohr oder der Ring jedoch die beiden Kerne nicht beführen. Das Rohr oder der Ring kann hierbei einen kreisförmigen, quadratischen oder anderswie geformten Querschnitt aufweisen. Mittels des Rohres bzw. des Rings wird der Nutzstrom durch die Verbindungsleitungen bzw. Kurzschlusswindung im Wesentlichen nicht beeinflusst, da sich die im Ferrit ausbildenden Magnetströme entgegengesetzt (antiparallel) laufender elektrischer Ströme im Wesentlichen aufheben. Andererseits werden Gleichtakt-Störströme, welche beide Verbindungsleitungen bzw. beide Leitungen der Kurzschlusswindung (parallel) durchströmen durch das Ferrit abgeschwächt.

Bevorzugterweise sind die beiden Transformatoren derart ausgebildet, dass die erste Primärwicklung und/oder die zweite Sekundärwicklung ein Mehrfaches an Windungen aufweisen, wie die erste Sekundärwicklung und/oder die zweite Primärwicklung. Dies führt insbesondere dazu, dass die Spannung am Übergang zwischen den beiden Transformatoren im Verhältnis zu der Eingangsspannung und der Ausgangsspannung des Transformatorenpaares klein ist. Vorteilhafterweise sind die erste Primärwicklung und/oder die zweite Sekundärwicklung derart dimensioniert, weisen insbesondere derart viele Windungen auf, dass eine an der ersten Sekundärwicklung anliegende erste Sekundärspannung und eine an der ersten Primärwicklung anliegende erste Primärspannung ein Verhältnis von höchstens 25% aufweisen.

Bei einer zweckmäßigen Ausführungsform ist vorgesehen, dass der erste Transformator und der zweite Transformator im Wesentlichen den gleichen Aufbau aufweisen. Insbesondere weisen in dieser Ausführungsform die erste Primärwicklung und die zweite Sekundärwicklung eine gleiche Anzahl an Windungen auf. Ferner können die Kerne der zwei Transformatoren, wenn vorhanden, gleich ausgebildet sein. Hierdurch wird sichergestellt, dass die am Ausgang des zweiten Transformators anliegende Spannung im Wesentlichen der an den Eingangsanschlüssen bzw. an den Eingang des ersten Transformators anliegenden Primärwechselspannung entspricht.

Gemäß einer bevorzugten Weiterbildung ist vorgesehen, dass der zweite Transformator und/oder der Gleichrichter von einer Abschirmung umgeben sind/ist, welche mit einem Anschluss der zweiten Primärwicklung des zweiten Transformators verbunden ist. Eine solche Abschirmung führt zu einer Entkopplung der beiden Transformatoren bzw. ihrer Kerne und kann zusätzlich oder alternativ zu einer Entkopplung mittels räumlicher Beabstandung der beiden Transformatoren erfolgen. Die Abschirmung wird vorzugsweise mittels eines Metallblechs oder eines Metallgitters erreicht, welches den Transformator und/oder den Gleichrichter bedeckt oder zumindest teilweise umgibt. Die Verbindung der Abschirmung mit der zweiten Primärwicklung kann hierbei einer Verbindung mit einer Verbindungsleitung zwischen den beiden Transformatoren oder mit der Kurzschlusswindung gleichgesetzt werden.

Bevorzugterweise ist vorgesehen, dass ein Anschluss der zweiten Primärwicklung des zweiten Transformators und/oder ein Anschluss der ersten Sekundärwicklung des ersten Transformators geerdet sind/ist. Auch hier kann davon gesprochen werden, dass insbesondere die Verbindungsleitung zwischen den beiden Transformatoren oder die Kurzschlusswindung geerdet ist. Ist eine vorangehend beschriebene Abschirmung des zweiten Transformators vorgesehen, so kann diese Abschirmung ebenfalls geerdet sein. Alternativ ist es möglich, dass lediglich die Abschirmung selbst geerdet ist, auch wenn keine Erdung der Transformatoranschlüsse stattfindet.

Bei einer bevorzugten Ausführungsform ist vorgesehen, dass ein Anschluss der zweiten Primärwicklung des zweiten Transformators dynamisch an einem Bezugspotential gehalten wird, welcher dem zu verstärkenden Signal folgt. Dieses Vorgehen wird auch als "bootstrapping" bezeichnet. Dadurch, dass die Verbindungsleitung bzw. die Kurzschlusswindung potentialmässig dynamisch dem Signal folgt, kann eine kapazitive Kopplung zur Erde bei gleichbleibender kapazitiver Entkopplung von der Primärseite des Transformatorpaares verringert werden. Das Bezugspotential wird hierzu vorzugsweise über einen Impedanzwandler mit dem jeweiligen Anschluss, mit der Verbindungsleitung oder mit der Kurzschlusswindung verbunden. Der Impedanzwandler kann beispielsweise mittels eines Pufferverstärkers gebildet sein, welcher einen Verstärkungsfaktor von im Wesentlichen eins aufweist. Bei dem Bezugspotential kann es sich insbesondere um das (mit einem Impedanzwandler entkoppelte) Signal selbst handeln. Vorzugsweise ist der Impedanzwandler mittels einer Gegentaktschaltung, insbesondere als komplementärer Emitterfolger, realisiert. In diesem Fall wird das Bezugspotential vorzugsweise an beiden Enden eines Vorspannwiderstands abgegriffen und den beiden Eingängen der Gegentaktschaltung zugeführt. Als Bootstrap-Signal wird dann das Signal am Ausgang der Gegentaktschaltung verwendet.

Über der zweiten Sekundärwicklung des zweiten Transformators liegt eine Wechselspannung an. Diese Wechselspannung führt zu einer gegenphasigen Schwingung an den beiden Anschlüssen der zweiten Sekundärwicklung. Von beiden Anschlüssen der Sekundärwicklung sind stets Streukapazitäten zur Erde oder zu dem vorangehend beschriebenen Bezugspotential vorhanden. Diese Streukapazitäten sind im allgemeinen Fall nicht gleich, so dass hieraus eine Gleichtakt-Störspannung resultieren kann, welche dann am Ausgang der Spannungsquelle anliegt.

Um diese weitere Gleichtakt-Störspannung zu verringern oder gänzlich zu vermeiden, ist bei einer bevorzugten Ausführungsform vorgesehen, dass ein Anschluss der zweiten Sekundärwicklung des zweiten Transformators über eine erste Korrektivkapazität und/oder dass ein weiterer Anschluss der zweiten Sekundärwicklung über eine zweite Korrektivkapazität mit einer Erdung verbunden ist. Mittels korrekter Auswahl des/der Korrektivkapazitäten können die genannten Streukapazitäten kompensiert werden. Die Korrektivkapazitäten haben vorzugsweise Werte im Bereich zwischen 0,5pF und 10pF. Es kann alternativ zu der vorangehend beschriebenen Erdung vorteilhafterweise vorgesehen sein, dass ein Anschluss der zweiten Sekundärwicklung des zweiten Transformators über eine erste Korrektivkapazität und/oder ein weiterer Anschluss der zweiten Sekundärwicklung über eine zweite Korrektivkapazität dynamisch mit einem Bezugspotential verbunden sind/ist. Auch hier ist das Bezugspotential vorzugsweise über einen Impedanzwandler mit der Korrektivkapazität oder den Korrektivkapazitäten verbunden, wobei der Impedanzwandler beispielsweise mittels eines Pufferverstärkers gebildet sein kann.

Die erste Korrektivkapazität und/oder die zweite Korrektivkapazität sind/ist vorzugsweise aus einem oder mehreren Kondensatoren gebildet. Die Korrektivkapazität weist vorzugsweise einen Wert zwischen 0,5 pF und 10 pF auf.

In allen vorangehend beschriebenen Ausführungsformen, bei denen eine erste Korrektivkapazität und gegebenenfalls eine zweite Korrektivkapazität vorgesehen sind, sind/ist vorteilhafterweise die erste Korrektivkapazität und/oder die zweite Korrektivkapazität einstellbar ausgebildet. Mittels der einstellbaren Korrektivkapazität(en) kann die Kompensation der Streukapazitäten unter Beobachtung des Ausgangssignals am Signalausgang des der Signalverstärkerschaltung vorgenommen werden, wobei angestrebt wird, die Gleichtakt-Störspannung in dem Ausgangssignal zu minimieren. Als einstellbare Korrektivkapazität wird vorzugsweise ein einstellbarer bzw. variabler Kondensator eingesetzt. Die Korrektivkapazitäten summieren sich mit den genannten Streukapazitäten zu jeweiligen Gesamtkapazitäten. Mit dem Angleichen beider Gesamtkapazitäten kann Symmetrie hergestellt werden. In diesem Fall heben sich die Beiträge beider Phasenlagen zur Gleichtakt-Störspannung an der Sekundärwicklung gegenseitig auf und die Gleichtakt-Störspannung verschwindet. Vorzugsweise wird die erste Korrektivkapazität so gewählt, dass mit der zweiten Korrektivkapazität ein Abgleich in beide Richtungen möglich ist, um auch bei fertigungsbedingten Variationen der Streukapazitäten stets auf Minimum abgleichen zu können.

Vorangehend wurden die drei unterschiedlichen Kompensationsansätze für die unabhängige Spannungsquelle: Erdung/Bootstrapping, Korrektivkapazität(en) und Abschirmung getrennt erläutert. Vorzugsweise werden jedoch zumindest zwei Kompensationsmethoden gleichzeitig eingesetzt. Bevorzugter werden alle drei Kompensationsmethoden zugleich implementiert.

Die vorangehend beschriebene, von der Verstärkerspannungsquelle unabhängige Spannungsquelle zum Versorgen der Vorspanndioden bzw. einer Vorspannschaltung kann in Form eines Spannungswandlers auch unabhängig von dem vorangehend beschriebenen Leistungsverstärker und auch in ganz anderen Anwendungsbereichen von Nutzen sein.

Die Erfindung betrifft also auch einen Spannungswandler zur Bereitstellung einer ausgangsseitigen Gleichspannung. Ferner betrifft die Erfindung ein System mit einem Spannungswandler und einem von dem Spannungswandler versorgten Verbraucher.

Ein derartiger Spannungswandler ist üblicherweise aus einem Transformator und einem Gleichrichter zusammengebaut. Der Transformator dient dazu, die Spannungsstärke einer oszillierenden Primärspannung an die Bedürfnisse einer nachfolgenden Schaltung anzupassen. Gleichzeitig wird eine galvanische Trennung zwischen der Primärspannung und der Schaltung erreicht. Im nachfolgenden Gleichrichter wird die angepasste Wechselspannung gleichgerichtet, um der Schaltung eine Gleichspannung zur Verfügung zu stellen. Der Gleichrichter umfasst in der Regel eine Diodenbrücke und einen Tiefpass.

Selbst bei sehr sorgfältiger Auslegung, lässt sich bei einem solchen Spannungswandler das Auftreten von Gleichtakt-Störspannungen in der Regel nicht gänzlich vermeiden. Insbesondere im Anwendungsbereich der medizinischen Messtechnik und in der gehobenen Audiotechnik können derartige Gleichtakt-Störspannungen das gemessene oder verstärkte Signal beeinflussen, so dass es zu unerwünschten Signalüberlagerungen kommen kann.

Es ist Aufgabe der Erfindung, einen Spannungswandler und ein System bereitzustellen, bei denen Gleichtakt-Störspannungen vermindert oder vermieden werden.

Die Aufgabe wird gemäß der Erfindung durch einen Spannungswandler mit den Merkmalen des Anspruchs 15 und durch ein System mit den Merkmalen des Anspruchs 23 gelöst. Vorteilhafte Weiterbildungen der Erfindung sind in den Unteransprüchen aufgeführt.

Die Erfindung beruht auf der Erkenntnis, dass bei einem herkömmlichen Transformator mit einer Primär- und einer Sekundärwicklung diese beiden Wicklungen nicht nur magnetisch, sondern auch kapazitiv gekoppelt sind. Durch die kapazitive Kopplung der Wicklungen gelangt ein Teil der primärseitigen Wechselspannung als Gleichtaktspannung bis an den Ausgang des Gleichrichters. Beide Ausgangsleitungen des Spannungswandlers führen diese Spannung gegen das primärseitige Bezugspotential. Um diese kapazitiv Kopplung zu vermindern, wird erfindungsgemäß anstelle eines einzelnen Transformators ein Transformatorpaar aus zwei Transformatoren eingesetzt, welche unmittelbar miteinander verbunden sind. Das bedeutet, die Sekundärwicklung bzw. Sekundärspule des ersten Transformators ist unmittelbar mit der Primärwicklung bzw. Primärspule des zweiten Transformators verbunden.

Die Verringerung der kapazitiven Kopplung erfolgt bereits in einem gewissen Maße dadurch, dass auf diese Weise der Abstand zwischen der Eingangswicklung (erste Primärwicklung) und der Ausgangswicklung (zweite Sekundärwicklung) des Transformatorpaares unabhängig von der Größe des Transformators erhöht werden kann. In dem gleichen Maße, in welchem die kapazitive Kopplung verringert wird, vermindert sich auch die an der Ausgangsspannung anliegende Gleichtaktstörung.

Dass die erste Sekundärwicklung des ersten Transformators mit der zweiten Primärwicklung des zweiten Transformators verbunden ist bedeutet insbesondere, dass eine elektrische Verbindung zwischen den beiden Wicklungen vorliegt, dass also die beiden Transformatoren hintereinander geschaltet sind. Vorzugsweise ist die erste Sekundärwicklung des ersten Transformators unmittelbar mit der zweiten Primärwicklung des zweiten Transformators verbunden. Das bedeutet insbesondere, dass der in der ersten Sekundärwicklung erzeugte Strom die zweite Primärwicklung durchfließt, ohne dass das Stromprofil wesentlich geändert wird. Bevorzugt sind zwischen der ersten Sekundärwicklung und der zweiten Primärwicklung in diesem Fall höchstens lediglich rein ohmsche Elemente, beispielsweise ein ohmscher Widerstand oder Leitungsstücke angeordnet.

Der zwischen der zweiten Sekundärwicklung und den Ausgangsanschlüssen angeordnete Gleichrichter weist vorzugsweise eine Diodenbrücke auf, um die an der zweiten Sekundärwicklung vorliegende Wechselspannung gleichzurichten. Anschließend kann die Welligkeit des gleichgerichteten Signals vorzugsweise mittels weiterer Schaltungen verringert werden. Insbesondere ist hier der Einsatz einer Serienspule bzw. Seriendrossel vorteilhaft, gegebenenfalls in Zusammenschaltung mit einem Ausgangskondensator als Tiefpassschaltung. Alternativ oder zusätzlich kann jede Diode des Gleichrichters mit einer Parallelschaltung von RC-Serienschaltungen (sogenannte Snubber) versehen sein. Hierdurch werden Oszillationen beim Sperrübergang der Dioden vermieden.

Mit dem Spannungswandler nach einer der vorangehend oder nachfolgend beschriebenen Ausführungsformen wird vorzugsweise eine signalverarbeitende Schaltung oder Schaltungsteil für sehr empfindliche Signale versorgt, die potentialmässig frei sind. Als potentialmässig frei wird eine Schaltung oder ein Schaltungsteil angesehen, welche(s) ihr/sein Potential dynamisch mit dem zu verarbeitenden Signal oder seinem Bezugspotential variieren kann. Der Spannungswandler gibt dabei eine vernachlässigbare Gleichtakt-Störspannung ab, so dass man mit ihm auch hochohmige Signalkreise versorgen kann, ohne das zu verarbeitende Signal zu beeinflussen.

Vorteilhafterweise wird mit dem Spannungswandler ein Verbraucher mit Gleichspannung versorgt, welcher ein Signal verarbeitet. Dementsprechend betrifft die Erfindung auch ein entsprechendes System mit einem Spannungswandler nach einem der vorangehend oder nachfolgend beschriebenen Ausführungsformen und einem mittels des Spannungswandlers versorgten Verbraucher. Vorteilhafterweise handelt es sich bei dem Verbraucher um einen Signalverstärker für das Signal. Bei dem Verbraucher kann es sich insbesondere um ein Signalmessgerät, beispielsweise um ein medizinisches Messgerät, oder um einen Audioverstärker handeln, insbesondere um eine signalverarbeitende Schaltung innerhalb der Endstufe eines Audioverstärkers.

An seinen Eingangsanschlüssen muss der Spannungswandler mit einer Primärwechselspannung versorgt werden. Die Frequenz der Primärwechselspannung, nachfolgend "Primärfrequenz", liegt vorzugsweise in einem Bereich zwischen 1 kHz und 10MHz, vorzugsweise zwischen 10 kHz und 500 kHz. Vorzugsweise liegt die Primärfrequenz der Primärwechselspannung von mehr als 1 kHz, 5 kHz, 10 kHz, 20 kHz oder 30 kHz. Die Primärwechselspannung kann beispielsweise mittels Umformung einer Gleichspannung in eine höherfrequente Wechselspannung erzeugt werden. Diese Umformung kann mittels elektronischen Leistungsschaltern oder mittels Oszillatoren und linearen Verstärkern erfolgen. Elektronische Leistungsschalter erzeugen hierbei eine Rechteck-Ansteuerung, was insbesondere für eine hohe Effizienz sorgt. Oszillatoren und lineare Verstärker sind hingegen für eine Sinus-Ansteuerung geeignet, welche den geringsten Störpegel liefert. Weiterhin ist bei Verwendung von Rechteckspannungen möglich, diese mit LC-Filtern "abzurunden", so dass man bei immer noch sehr guter Effizienz einen weiter reduzierten Störpegel erzielt.

Ist der Spannungswandler in einem System mit einem Verbraucher verbunden, welcher ein Signal verarbeitet, dann ist die Primärfrequenz vorzugsweise so gewählt, dass die Primärwechselspannung keine zusätzlichen Spannungskomponenten in dem verarbeiteten Signal erzeugt, beispielsweise aufgrund von Koppeleffekten. Handelt es sich bei dem Verbraucher um einen Audioverstärker, dann liegt die Primärfrequenz vorzugsweise zwischen, aber bevorzugt fernab von, einer Audiobandgrenze von etwa 20 kHz und der Grenzfrequenz des Audioverstärker, welche üblicherweise einige hundert kHz beträgt. Je weiter die Primärfrequenz von der Verstärker-Grenzfrequenz entfernt liegt, desto effektiver werden mögliche Primärwechselspannungs-Störungen aufgrund der Gegenkopplung im Verstärker unterdrückt. Beispielsweise wäre bei einer Verstärker-Grenzfrequenz von 500 kHz eine Primärfrequenz von etwa 100 kHz angebracht. Der Abstand zur Audiobandgrenze betrüge dann 80 kHz und der Abstand zur Verstärker-Grenzfrequenz 400 kHz.

Vorzugsweise weist der erste Transformator einen ersten Kern auf, welcher von einem zweiten Kern des zweiten Transformators getrennt ist, so dass der magnetische Fluss des ersten Kerns den zweiten Kern im Wesentlichen nicht durchdringt.

In einer vorteilhaften Weiterbildung ist vorgesehen, dass die erste Sekundärwicklung und/oder die zweite Primärwicklung maximal fünf Windungen, vorzugsweise maximal drei Windungen, bevorzugt maximal eine Windung aufweist/aufweisen. Vorzugsweise werden die erste Sekundärwicklung und die zweite Primärwicklung durch eine Kurzschlusswindung gebildet, welche beide Kerne der zwei Transformatoren durchdringt. Die Kurzschlusswindung kann hierbei einen Kreis um jeweils einen Schenkel der beiden Kerne bilden, oder sich achtförmig zwischen diesen beiden Schenkeln kreuzen. Eine geringe Anzahl an Windungen oder sogar eine solche Kurzschlusswindung reduziert die oben beschriebene kapazitive Kopplung erheblich, weil die Energieübertragung vom ersten Transformator zu dem zweiten Transformator mittels eines hohen Stroms bei gleichzeitig sehr geringer Spannung erfolgt. Sowohl aufgrund der geringeren Spannung als auch aufgrund der geringeren Koppelkapazität von nur einer oder wenigen Windungen wird die kapazitive Kopplung zwischen der ersten Primärwicklung und der zweiten Sekundärwicklung erheblich reduziert.

Die Verbindungsleitungen zwischen den beiden Transformatoren oder die Kurzschlusswindung kann vorteilhafterweise zusätzlich mittels Verdrillen induktionsarm ausgeführt sein. Auf diese Weise ist es möglich, den Abstand zwischen den beiden Transformatoren bzw. zwischen den beiden Kernen weiter zu vergrößern, was die kapazitive Kopplung zusätzlich reduziert.

Bevorzugterweise werden die Verbindungsleitungen zwischen den beiden Transformatoren oder wird die Kurzschlusswindung durch ein Rohr oder ein Ring aus Ferritmaterial hindurch geführt, welches/welcher sich von einem Kern des ersten Transformators zu einem Kern des zweiten Transformators erstreckt, falls diese Kerne vorhanden sind. Hierbei darf das Rohr oder der Ring jedoch die beiden Kerne nicht beführen. Das Rohr oder der Ring kann hierbei einen kreisförmigen, quadratischen oder anderswie geformten Querschnitt aufweisen. Mittels des Rohres bzw. des Rings wird der Nutzstrom durch die Verbindungsleitungen bzw. Kurzschlusswindung im Wesentlichen nicht beeinflusst, da sich die im Ferrit ausbildenden Magnetströme entgegengesetzt (antiparallel) laufender elektrischer Ströme im Wesentlichen aufheben. Andererseits werden Gleichtakt-Störströme, welche beide Verbindungsleitungen bzw. beide Leitungen der Kurzschlusswindung (parallel) durchströmen durch das Ferrit abgeschwächt.

Bevorzugterweise sind die beiden Transformatoren derart ausgebildet, dass die erste Primärwicklung und/oder die zweite Sekundärwicklung ein Mehrfaches oder ein Vielfaches an Windungen aufweisen, welche die erste Sekundärwicklung und/oder die zweite Primärwicklung besitzt. Dies führt insbesondere dazu, dass die Spannung am Übergang zwischen den beiden Transformatoren im Verhältnis zu der Eingangsspannung und der Ausgangsspannung des Transformatorenpaares klein ist. Vorteilhafterweise sind die erste Primärwicklung und/oder die zweite Sekundärwicklung derart dimensioniert, weisen insbesondere derart viele Windungen auf, dass eine an der ersten Sekundärwicklung anliegende erste Sekundärspannung und eine an der ersten Primärwicklung anliegende erste Primärspannung ein Verhältnis von höchstens 25% aufweisen.

Bei einer zweckmäßigen Ausführungsform ist vorgesehen, dass der erste Transformator und der zweite Transformator im Wesentlichen den gleichen Aufbau aufweisen. Insbesondere weisen in dieser Ausführungsform die erste Primärwicklung und die zweite Sekundärwicklung eine gleiche Anzahl an Windungen auf. Ferner können die Kerne der zwei Transformatoren, wenn vorhanden, gleich ausgebildet sein. Hierdurch wird sichergestellt, dass die am Ausgang des zweiten Transformators anliegende Spannung im Wesentlichen der an den Eingangsanschlüssen bzw. an den Eingang des ersten Transformators anliegenden Primärwechselspannung entspricht.

Gemäß einer bevorzugten Weiterbildung ist vorgesehen, dass der zweite Transformator und/oder der Gleichrichter von einer Abschirmung umgeben sind/ist, welche mit einem Anschluss der zweiten Primärwicklung des zweiten Transformators verbunden ist. Eine solche Abschirmung führt zu einer Entkopplung der beiden Transformatoren bzw. ihrer Kerne und kann zusätzlich oder alternativ zu einer Entkopplung mittels räumlicher Beabstandung der beiden Transformatoren erfolgen. Die Abschirmung wird vorzugsweise mittels eines Metallblechs oder eines Metallgitters erreicht, welches den Transformator und/oder den Gleichrichter bedeckt oder zumindest teilweise umgibt. Die Verbindung der Abschirmung mit der zweiten Primärwicklung kann hierbei einer Verbindung mit einer Verbindungsleitung zwischen den beiden Transformatoren oder mit der Kurzschlusswindung gleichgesetzt werden.

Bevorzugterweise ist vorgesehen, dass ein Anschluss der zweiten Primärwicklung des zweiten Transformators und/oder ein Anschluss der ersten Sekundärwicklung des ersten Transformators geerdet sind/ist. Auch hier kann davon gesprochen werden, dass insbesondere die Verbindungsleitung zwischen den beiden Transformatoren oder die Kurzschlusswindung geerdet ist. Ist eine vorangehend beschriebene Abschirmung des zweiten Transformators vorgesehen, so kann diese Abschirmung ebenfalls geerdet sein. Alternativ ist es möglich, dass lediglich die Abschirmung selbst geerdet ist, auch wenn keine Erdung der Transformatoranschlüsse stattfindet.

Ist der Spannungswandler in einem System mit einem Verbraucher verbunden, welcher ein Signal verarbeitet, dann kann alternativ zu der vorangehend beschriebenen Erdung vorteilhafterweise vorgesehen sein, dass ein Anschluss der zweiten Primärwicklung des zweiten Transformators, ein Anschluss der ersten Sekundärwicklung des ersten Transformators, die Verbindungsleitung zwischen den beiden Transformatoren und/oder die Kurzschlusswindung dynamisch an einem Bezugspotential gehalten wird, welcher dem im Verbraucher verarbeiteten Signal folgt.

Dieses Vorgehen wird auch als "bootstrapping" bezeichnet. Dadurch, dass die Verbindungsleitung bzw. die Kurzschlusswindung potentialmässig dynamisch dem Signal folgt, kann eine kapazitive Kopplung zur Erde bei gleichbleibender kapazitiver Entkopplung von der Primärseite des Transformatorpaares verringert werden. Das Bezugspotential wird hierzu vorzugsweise über einen Impedanzwandler mit dem jeweiligen Anschluss, mit der Verbindungsleitung oder mit der Kurzschlusswindung verbunden. Der Impedanzwandler kann beispielsweise mittels eines Pufferverstärkers gebildet sein, welcher einen Verstärkungsfaktor von im Wesentlichen eins aufweist. Vorzugsweise ist der Impedanzwandler mittels einer Gegentaktschaltung, insbesondere als komplementärer Emitterfolger, realisiert. Bei dem Bezugspotential kann es sich insbesondere um das Signal selbst handeln. Handelt es sich bei dem Verbraucher um einen Audioverstärker, dann kann das Bezugspotential vorzugsweise am Verstärkereingang, bevorzugter am Eingang einer Endstufe des Audioverstärker angegriffen werden.

Über der zweiten Sekundärwicklung des zweiten Transformators liegt eine Wechselspannung an. Diese Wechselspannung ist an beiden Anschlüssen der zweiten Sekundärwicklung zueinander gegenphasig. Von beiden Anschlüssen der Sekundärwicklung sind stets Streukapazitäten zur Erde oder zu dem vorangehend beschriebenen Bezugspotential vorhanden. Diese Streukapazitäten sind im allgemeinen Fall nicht gleich, so dass hieraus eine Gleichtakt-Störspannung resultieren kann, welche dann am Ausgang des Spannungswandlers anliegt.

Um diese weitere Gleichtakt-Störspannung zu verringern oder gänzlich zu vermeiden, ist bei einer bevorzugten Ausführungsform vorgesehen, dass ein Anschluss der zweiten Sekundärwicklung des zweiten Transformators über eine erste Korrektivkapazität und/oder dass ein weiterer Anschluss der zweiten Sekundärwicklung über eine zweite Korrektivkapazität mit einer Erdung verbunden ist. Mittels korrekter Auswahl des/der Korrektivkapazitäten können die genannten Streukapazitäten kompensiert werden. Die Korrektivkapazitäten haben vorzugsweise Werte im Bereich zwischen 0,5pF und 10pF. Ist der Spannungswandler in einem System mit einem Verbraucher verbunden, welcher ein Signal verarbeitet, dann kann alternativ zu der vorangehend beschriebenen Erdung vorteilhafterweise vorgesehen sein, dass ein Anschluss der zweiten Sekundärwicklung des zweiten Transformators über eine erste Korrektivkapazität und/oder ein weiterer Anschluss der zweiten Sekundärwicklung über eine zweite Korrektivkapazität dynamisch mit einem Bezugspotential verbunden sind/ist. Auch hier ist das Bezugspotential vorzugsweise über einen Impedanzwandler mit der Korrektivkapazität oder den Korrektivkapazitäten verbunden, wobei der Impedanzwandler beispielsweise mittels eines Pufferverstärkers gebildet sein kann.

Die erste Korrektivkapazität und/oder die zweite Korrektivkapazität sind/ist vorzugsweise aus einem oder mehreren Kondensatoren gebildet. Die Korrektivkapazität weist vorzugsweise einen Wert zwischen 0,5 pF und 20 pF auf.

In allen vorangehend beschriebenen Ausführungsformen, bei denen eine erste Korrektivkapazität und gegebenenfalls eine zweite Korrektivkapazität vorgesehen sind, sind/ist vorteilhafterweise die erste Korrektivkapazität und/oder die zweite Korrektivkapazität einstellbar ausgebildet. Mittels der einstellbaren Korrektivkapazität(en) kann die Kompensation der Streukapazitäten unter Beobachtung des Ausgangssignals des Verbrauchers vorgenommen werden, wobei angestrebt wird, die Gleichtakt-Störspannung in dem Ausgangssignal zu minimieren. Als einstellbare Korrektivkapazität wird vorzugsweise ein einstellbarer bzw. variabler Kondensator eingesetzt. Die Korrektivkapazitäten summieren sich mit den genannten Streukapazitäten zu jeweiligen Gesamtkapazitäten. Mit dem Angleichen beider Gesamtkapazitäten kann Symmetrie hergestellt werden. In diesem Fall heben sich die Beiträge beider Phasenlagen zur Gleichtakt-Störspannung an der Sekundärwicklung gegenseitig auf und die Gleichtakt-Störspannung verschwindet. Vorzugsweise wird die erste Korrektivkapazität so gewählt, dass mit der zweiten Korrektivkapazität ein Abgleich in beide Richtungen möglich ist, um auch bei fertigungsbedingten Variationen der Streukapazitäten stets auf Minimum abgleichen zu können.

Vorangehend wurden die drei unterschiedlichen Kompensationsansätze: Erdung/Bootstrapping, Korrektivkapazität(en) und Abschirmung getrennt erläutert. Vorzugsweise werden jedoch zumindest zwei Kompensationsmethoden gleichzeitig eingesetzt. Bevorzugter werden alle drei Kompensationsmethoden zugleich implementiert.

Die Erfindung wird im Folgenden anhand von Ausführungsbeispielen unter Bezugnahme auf die Figuren erläutert. Hierbei zeigen:
- Fig. 1: ein Schaltplan einer Signalverstärkerschaltung gemäß dem Stand der Technik;
- Fig. 2: ein Schaltplan einer Signalverstärkerschaltung gemäß einer Ausführungsform der Erfindung;
- Fig. 3: ein Schaltplan einer Konstantstromquelle zur Versorgung von Vorspanndioden gemäß einer bevorzugten Ausführungsform;
- Fig. 4: ein Schaltplan einer potentialfreien Spannungsquelle gemäß einer bevorzugten Ausführungsform zur Versorgung der Vorspanndioden;
- Fig. 5: ein Schaltplan eines Spannungswandlers gemäß einer bevorzugten Ausführungsform;
- Fig. 6: ein Schaltplan eines Spannungswandlers gemäß einer weiteren bevorzugten Ausführungsform mit Bootstrapping;
- Fig. 7: ein Schaltplan eines Spannungswandlers gemäß einer weiteren bevorzugten Ausführungsform mit Bootstrapping und Korrektivkapazitäten; und
- Fig. 8: ein Schaltplan eines Spannungswandlers gemäß einer weiteren bevorzugten Ausführungsform mit drei Kompensationsmaßnahmen.

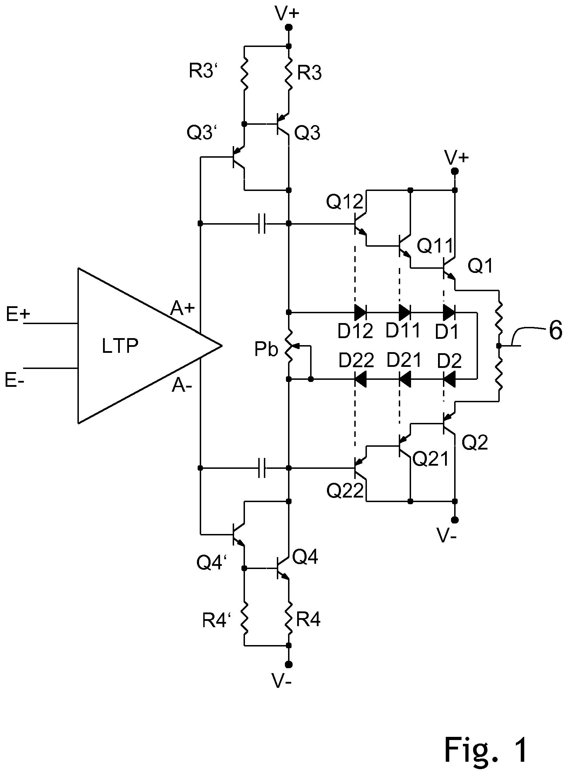

Die Fig. 1 zeigt einen Schaltplan einer Signalverstärkerschaltung gemäß dem Stand der Technik. Diese bekannte Schaltung, welche als Audioverstärker ausgebildet ist, kann grob in eine Spannungsverstärkerstufe (VAS - voltage amplifier stage) und einer Ausgangsstufe unterteilt werden.

Die VAS ist aus einem positiven Teil gebildet, welcher eine modifizierte Darlingtonstufe aus zwei Transistoren Q3, Q3' und zwei Widerständen R3, R3' aufweist, und einem negativen Teil, welcher eine weitere modifizierte Darlingtonstufe aus zwei Transistoren Q4, Q4' und zwei Widerständen R4, R4' aufweist. Eine Eingangsdifferenzverstärkerstufe LTP (LTP - long-tailed pair) dient dazu, ein an den Vorverstärkereingängen E+, E- anliegendes Signal zu verstärken und an den Vorverstärkerausgängen A+, A- bereitzustellen. Das vorverstärkte Signal durchläuft die Spannungsverstärkerstufe, wobei ein positiver Schwingungszyklus des Signals durch den positiven Teil und ein negativer Schwingungszyklus durch den negativen Teil der Spannungsverstärkerstufe laufen, um an die Ausgangsstufe zu gelangen.

Die Ausgangsstufe ist aus ersten Verstärkertransistoren Q1, Q11, Q12 und zweiten Verstärkertransistoren Q2, Q21, Q22 in einer Gegentaktschaltung zusammengesetzt. Die hier dargestellten drei ersten Verstärkertransistoren Q1, Q11, Q12 sind zu einer Darlingtonschaltung miteinander verbunden, ebenso wie die drei zweiten Verstärkertransistoren Q2, Q21, Q22. Das mittels der Sperrspannungsverstärkerstufe und der Ausgangsstufe verstärkte Audiosignal liegt schließlich am Signalausgang 6 an und kann dazu verwendet werden, eine Lautsprechervorrichtung (nicht dargestellt) anzusteuern.

Die Spannungsverstärkerstufe und die Ausgangsstufe werden beide mittels der Verstärkerspannungsquelle V+, V- versorgt. Eine Diodenkette aus Vorspanndioden (auch Fühlerdioden genannt) D1, D11, D12, D2, D21, D22 ist parallel zu den Verstärkertransistoren Q1, Q11, Q12, Q2, Q21, Q22 angeordnet, um eine Vorspannung bereitzustellen, welche dem Temperaturverhalten der Verstärkertransistoren Q1, Q11, Q12, Q2, Q21, Q22 folgt. Hierzu ist jede der Vorspanndioden D1, D11, D12, D2, D21, D22 mit einem zugehörigen der Verstärkertransistoren Q1, Q11, Q12, Q2, Q21, Q22 thermisch gekoppelt. In diesem Fall ist die Vorspanndiode D1 mit dem Verstärkertransistor Q1 gekoppelt, die Vorspanndiode D2 mit dem Verstärkertransistor Q2, usw. Die thermische Kopplung ist in der Fig. 1 mittels gestrichelten Linien angedeutet und kann beispielsweise mittels Anordnen von Transistor und Diode in einem gemeinsamen Gehäuse oder mittels Befestigen der Diode an einen Kühlkörper des zugehörigen Transistors erreicht werden.

Die Schwellspannung einer Diode weist einen negativen Temperaturkoeffizienten auf, genauso wie die Schwellspannung des Basis-Emitter-Übergangs eines Transistors. Das Temperaturverhalten der Diodenkette aus den Vorspanndioden D1, D11, D12, D2, D21, D22 spiegelt somit das Temperaturverhalten der in Reihe verbundenen Basis-Emitter-Übergänge der Verstärkertransistoren Q1, Q11, Q12, Q2, Q21, Q22 wieder, was dazu führt, dass auch die mittels der Diodenkette erzeugte Vorspannung ein entsprechendes Temperaturverhalten erfährt.

Der Ruhestrom der Spannungsverstärkerstufe fließt durch die Diodenkette. In der Praxis unterscheiden sich jedoch die Temperaturkoeffizienten der Schwellspannungen von Diode und Transistor um einen bekannten Faktor, vorliegend etwa um den Faktor 1,202. Zudem können in der Praxis die Vorspanndioden nicht frei gewählt werden, da in der Regel Verstärkertransistoren eingesetzt werden, welche jeweils mit einer Vorspanndiode in einem gemeinsamen Gehäuse integriert sind. Um diese Diskrepanzen auszugleichen, ist ein zu der Diodenkette parallel angeordneter Vorspannpotentiometer Pb vorgesehen, mit welchem ein Offsetwert der Vorspannung auf möglichst geringe Verzerrungen des Ausgangssignals am Signalausgang 6 bei mittlerer zu erwartender Arbeitstemperatur des Verstärkers hin eingestellt wird. Dieser Offsetwert hängt vom Ruhestrom durch die Spannungsverstärkerstufe ab. Dieser Ruhestrom ist wiederum stark temperaturabhängig, vor allem dann, wenn die Ausgangsstufe auf Schnelligkeit hin optimiert wird. Damit ergibt sich eine ungewollte Schwankung der Vorspannung.

Um derartige Schwankungen zu verringern oder sogar zu vermeiden, werden die Vorspanndioden D1, D11, D12, D2, D21, D22 erfindungsgemäß durch eine Präzisions-Konstantstromquelle Ib gespeist, welche wiederum mittels einer von der Verstärkerspannungsquelle V+, V- unabhängigen Spannungsquelle Vb versorgt wird. Ein Vorspannverstärker Ab ist vorgesehen, um die Anpassung der Temperaturkoeffizienten der Vorspanndioden D1, D11, D12, D2, D21, D22 an denen der Verstärkertransistoren Q1, Q11, Q12, Q2, Q21, Q22 vorzunehmen. Er weist einen entsprechenden Verstärkungsfaktor von etwa 1,202 auf.

Der Ausgang des Vorspannverstärkers Ab kann sowohl Strom abgeben als auch Strom aufnehmen. Wäre dieser Vorspannverstärkers Ab nicht vorhanden, dann entstünde über dem Vorspannwiderstand Rb ein durch den Ruhestrom der Spannungsverstärkerstufe bedingter Spannungsabfall. Wenn dieser Spannungsabfall über dem Wert liegt, der einer eingestellten optimalen Vorspannung entspricht, dann nimmt der Vorspannverstärker Ab so viel Strom auf, dass sich wieder die korrekte Vorspannung einstellt. Ist der Ruhestrom der Spannungsverstärkerstufe dagegen zu gering, um den benötigten Spannungsabfall zu erzeugen, dann gibt der Vorspannverstärker Ab entsprechend einen zusätzlichen Strom aus, um die gewünschte Vorspannung zu erreichen. Dies hat zur Folge, dass die über dem Vorspannwiderstand Rb abfallende Vorspannung unabhängig vom Ruhestrom der Spannungsverstärkerstufe ist und zudem exakt den Temperaturgang der Verstärkertransistoren kompensiert.

Bei dem Vorspannverstärker Ab handelt es sich um einen Präzisionsverstärker. Er ist vorzugsweise dergestalt frequenzkompensiert, dass er kapazitive Lasten treiben kann.

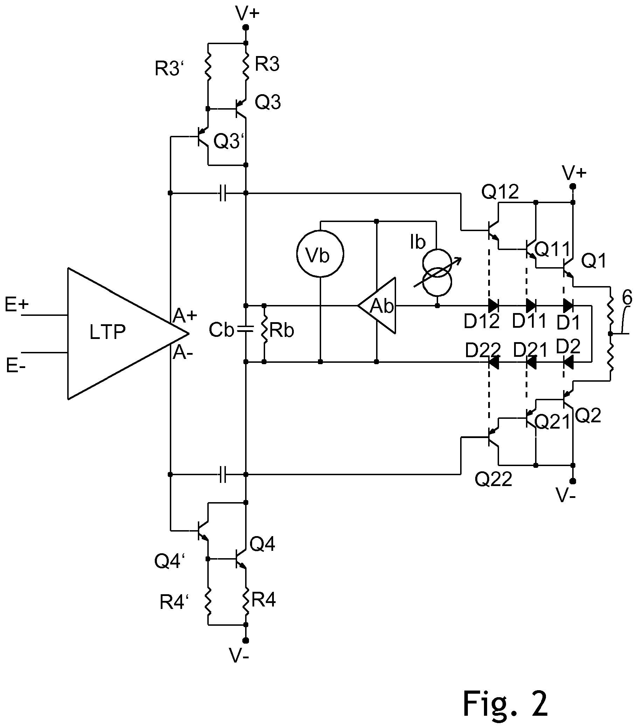

Bei der in der Fig. 2 gezeigten Anordnung aus Vorspannverstärker Ab, Konstantstromquelle Ib und Spannungsquelle Vb handelt es sich lediglich um eine schematische Darstellung einer Vorspannschaltung zur Einstellung und Regulierung der mittels der Diodenkette erzeugten Vorspannung. Diese Vorspannschaltung arbeitet im Wesentlichen im Gleichspannungsbereich. Um eine Interaktion mit der Signalfrequenz auszuschließen, ist ein Vorspannkondensator Cb vorgesehen. Dieser Vorspannkondensator Cb stellt im Frequenzbereich des zu verstärkenden Signals einen Kurzschluss dar. Damit ist es nicht notwendig, die Funktionsgruppen der Vorspannschaltung auf gute Eigenschaften im Signalfrequenzbereich bzw. Signalfrequenzband hin auszulegen.

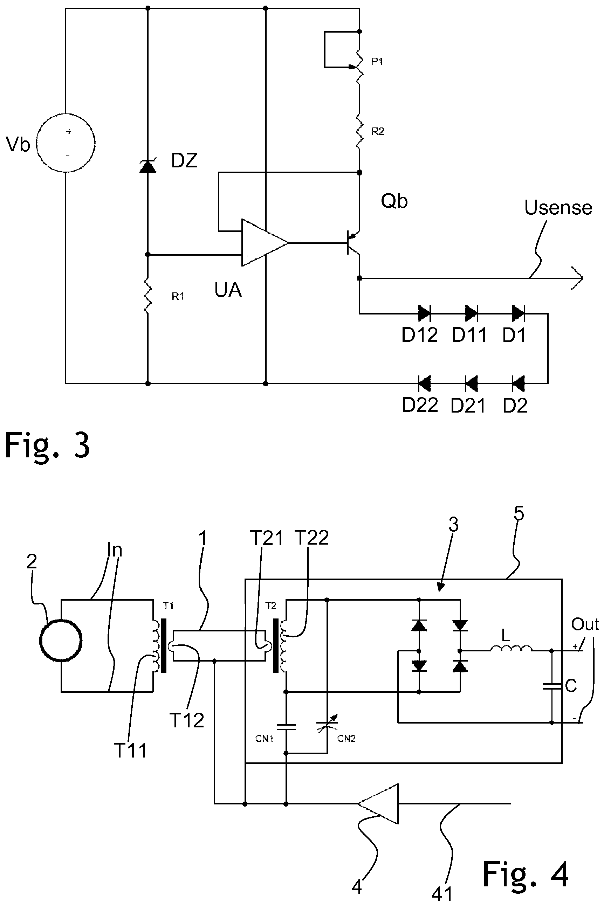

Eine vorteilhafte Ausführungsform der Konstantstromquelle Ib der Vorspannschaltung wird in der Fig. 3 dargestellt. Die Konstantstromquelle Ib ist in dieser Ausführungsform mittels eines Operationsverstärkers UA und einigen weiteren Bauelementen verwirklicht.

An einer vorzugsweise als Bandgap-Referenz mit einer zusätzlichen, in der Fig. 3 nicht dargestellten Rückkopplung implementierten Zenerdiode DZ, welche als Shunt-Referenzspannungsquelle fungiert, fällt eine Spannung mit hoher Absolutgenauigkeit ab, die zudem sehr temperaturstabil ist. Der Operationsverstärker UA prägt diese, an seinem positiven Eingang anliegende Spannung über einer Serienschaltung aus einem Potentiometer P1 und einem Widerstand R1 ein. Damit ist der Stromfluss durch den Potentiometer P1 und den Widerstand R1 gleich der über der Zenerdiode DZ abfallenden Spannung geteilt durch die Summe aus den Widerständen des Potentiometers P1 und des Widerstands R1. Dieser Strom fließt auch in den Emittereingang eines Transistors Qb, dessen Basis mit dem Ausgang des Operationsverstärkers UA verbunden ist. Der Basisstrom des Transistors Qb kann im Rahmen der hier relevanten Genauigkeit vernachlässigt werden, so dass auch der Kollektorstrom des Transistors Qb eingeprägt ist und dem Strom gleicht, welcher durch den Potentiometer P1 und den Widerstand R1 fließt. Damit ist der Kollektorstrom, der auch durch die Diodenkette der Vorspanndioden D1, D11, D12, D2, D21, D22 fließt, unabhängig von dem Potential, der am Kollektor anliegt. Es fließt somit ein definierter und temperaturstabiler Strom durch die Vorspanndioden D1, D11, D12, D2, D21, D22. Der Strom dieser Konstantstromquelle Ib wird durch die Einstellung des Potentiometers P1 gesteuert. Das mit "Usense" gekennzeichnete Signal am Kollektor des Transistors Qb wird als Eingangssignal dem Vorspannverstärker Ab aus der Fig. 2 zugeführt.

Der Operationsverstärker UA und auch die übrigen Elemente der Vorspannschaltung in Fig. 3 werden mittels der potentialfreien Spannungsquelle Vb versorgt. Eine bevorzugte Ausführungsform für die Spannungsquelle Vb wird in der Fig. 4 dargestellt. Die Spannungsquelle Vb weist Eingangsanschlüsse In und Ausgangsanschlüsse Out auf. Die Eingangsanschlüsse In werden durch eine Primärwechselspannung 2 gespeist. An den Ausgangsanschlüssen Out stellt die Spannungsquelle Vb die Gleichspannung bereit, welche die Vorspannschaltung antreibt, die beispielsweise wie in Fig. 3 dargestellt aufgebaut sein kann.

Zentralstück der Spannungsquelle Vb sind zwei hintereinander weg miteinander verbundene Transformatoren T1, T2 mit jeweils Primärwicklungen T11, T21 und Sekundärentwicklungen T12, T22. Die erste Primärwicklung T11 wird über die Eingangsanschlüsse In mit der Primärwechselspannung 2 versorgt, während an der zweiten Sekundärwicklung T22 eine Wechselspannung anliegt, die bei baugleichen Transformatoren T1, T2 im Wesentlichen gleich der Primärwechselspannung 2 ist. Die erste Sekundärwicklung T12 und die zweite Primärwicklung T21 werden durch eine Kurzschlusswindung 1 gebildet. Bei dieser handelt sich um ein kurzgeschlossenes Stück Draht, welches die beiden Kerne der Transformatoren T1, T2 durchläuft.

Die in der zweiten Sekundärwicklung T22 gebildete Wechselspannung wird mittels eines Gleichrichters gleichgerichtet, der aus einer Diodenbrücke 3 und einem Tiefpass aus einer Gleichrichter-Induktivität L und einer Gleichrichter-Kapazität C zusammengesetzt ist.

Die Kurzschlusswindung 1 wird auf einem Bezugspotenzial gehalten. Dies wird als Bootstrapping bezeichnet und erfolgt dadurch, dass die Kurzschlusswindung 1 über einen Impedanzwandler 4 mit dem Bezugspotenzial verbunden wird, welcher an einem Impedanzwandler-Eingang 41 anliegt. Bei dem Bezugspotential handelt sich um das Signal, welches in der Signalverstärkerschaltung verstärkt wird, oder das Bezugspotential folgt diesem Signal. Das Bezugspotential wird in der hier gezeigten Ausführungsform am Vorspannwiderstand Rb abgegriffen und am Impedanzwandler-Eingang 41 dem Impedanzwandler 4 zugeführt.

Zusätzlich zu dem Bootstrapping der Kurzschlusswindung 1 werden die beiden Anschlüsse des Ausgangs des zweiten Transformators T2, nämlich die beiden Enden der zweiten Sekundärwicklung T22 über eine erste Korrektivkapazität CN1 und eine zweite Korrektivkapazität CN2 mit dem Bezugspotential verbunden. Die zweite Korrektivkapazität CN2 ist hierbei als einstellbarer Kondensator ausgebildet. Mittels der beiden Korrektivkapazitäten CN1, CN2 werden die von jedem Ende der zweiten Sekundärwicklung T22 zu dem Bezugspotential vorhandenen Streukapazitäten ausgeglichen, indem die zweite Korrektivkapazität CN2 unter Beobachtung des Ausgangssignals am Signalausgang 6 der Signalverstärkerschaltung justiert wird.

Schließlich wird in der Fig. 4 schematisch eine Abschirmung 5 des zweiten Transformators T2, des Gleichrichters aus der Diodenbrücke 3 und der LC-Schaltung, sowie der Korrektivkapazitäten CN1, CN2 symbolisiert. Bei der Abschirmung 5 handelt es sich insbesondere um einen Metallkäfig, der die Schaltung umschließt und damit die abgeschirmten Komponenten bedeckt. Die Abschirmung wird ebenfalls an dem Bezugspotential gehalten.

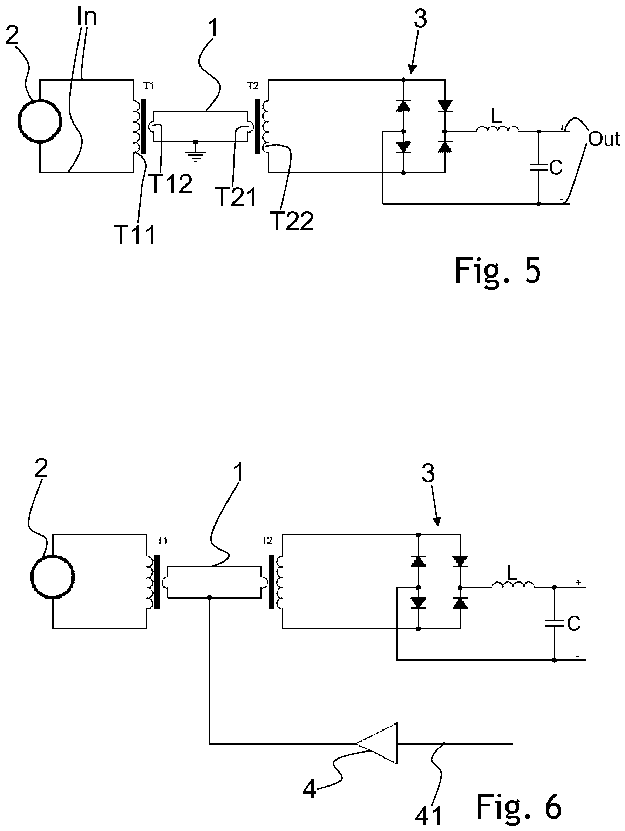

Der nachfolgend in Bezug auf die Fig. 5 bis 8 beschriebene Spannungswandler kann als von der Verstärkerspannungsquelle unabhängige Spannungsquelle zum Versorgen der Vorspanndioden bzw. einer Vorspannschaltung wie vorangehend beschrieben eingesetzt werden. Wie einleitend erläutert, kann der Spannungswandler jedoch stattdessen auch für die Bereitstellung einer Spannung für andere Verbraucher und in ganz anderen Anwendungsgebieten eingesetzt werden.

In der Fig. 5 wird schematisch ein Spannungswandler gemäß einer bevorzugten Ausführungsform mittels eines Schaltplans dargestellt. Wie auch in den folgenden Figuren, sind hier lediglich die zur Beschreibung der Erfindung wichtigsten Komponenten gezeigt. Der Spannungswandler weist Eingangsanschlüsse In und Ausgangsanschlüsse Out auf. Die Eingangsanschlüsse In werden durch eine Primärwechselspannung 2 gespeist. An den Ausgangsanschlüssen Out stellt der Spannungswandler eine Gleichspannung zur Versorgung eines oder mehrerer Verbraucher bereit, wobei die Verbraucher in den Figuren nicht dargestellt sind.

Zentralstück des Spannungswandlers sind zwei hintereinander weg miteinander verbundene Transformatoren T1, T2 mit jeweils Primärwicklungen T11, T21 und Sekundärentwicklungen T12, T22. Die erste Primärwicklung T11 wird über die Eingangsanschlüsse In mit der Primärwechselspannung 2 versorgt, während an der zweiten Sekundärwicklung T22 eine Wechselspannung anliegt, die bei baugleichen Transformatoren T1, T2 im Wesentlichen gleich der Primärwechselspannung 2 ist. Die erste Sekundärwicklung T12 und die zweite Primärwicklung T21 werden durch eine Kurzschlusswindung 1 gebildet. Bei dieser handelt sich um ein kurzgeschlossenes Stück Draht, welches die beiden Kerne der Transformatoren T1, T2 durchläuft. Vorzugsweise kreuzt sich die Kurzschlusswindung 1 zwischen den beiden Kernen und bildet so eine acht. Die Kurzschlusswindung 1 ist in der Ausführungsform gemäß Fig. 5 geerdet.

Die in der zweiten Sekundärwicklung T22 gebildete Wechselspannung wird mittels eines Gleichrichters gleichgerichtet, der aus einer Diodenbrücke 3, und einem Tiefpass aus einer Gleichrichter-Induktivität L und einer Gleichrichter-Kapazität C zusammengesetzt ist.

Die gemäß dieser ersten Ausführungsform vorgenommene Erdung der Kurzschlusswindung 1 stellt eine Maßnahme dar, Gleichtakt-Störspannungen an den Ausgangsanschlüssen Out zu verringern oder vermeiden. Andere Maßnahmen werden in den nachfolgenden Fig. 6 bis 4 schematisch dargestellt. Bei diesen nachfolgenden Ausführungsbeispielen kann der grundsätzliche Aufbau des Spannungswandlers wie vorangehend beschriebenen erhalten bleiben.

Bei der Ausführungsform gemäß Fig. 6 wird die Kurzschlusswindung 1 anstelle einer Erdung auf einem Bezugspotenzial gehalten. Dies erfolgt dadurch, dass die Kurzschlusswindung 1 über einen Impedanzwandler 4 mit dem Bezugspotenzial verbunden wird, welcher an Impedanzwandler-Eingang 41 anliegt. Der Spannungswandler versorgt über seine Ausgangsanschlüsse Out einen Verbraucher (nicht dargestellt). Bei dem Bezugspotential handelt sich um ein Signal, welches in diesem Verbraucher verarbeitet wird, oder das Bezugspotential folgt diesem im Verbraucher verarbeiteten Signal.

Zusätzlich zu dem in der Fig. 6 beschriebenen Bootstrapping der Kurzschlusswindung 1, werden die beiden Anschlüsse des Ausgangs des zweiten Transformators T2, nämlich die beiden Enden der zweiten Sekundärwicklung T22 über eine erste Korrektivkapazität CN1 und eine zweite Korrektivkapazität CN2 mit dem Bezugspotential verbunden. Alternativ zu dem Bezugspotenzial können die beiden Korrektivkapazitäten CN1, CN2 ebenso geerdet sein, wie die Kurzschlusswindung 1 in der Fig. 5.

Die zweite Korrektivkapazität CN2 ist hierbei als einstellbarer Kondensator ausgebildet. Mittels der beiden Korrektivkapazitäten CN1, CN2 werden die von jedem Ende der zweiten Sekundärwicklung T22 zu dem Bezugspotential vorhandenen Streukapazitäten ausgeglichen, indem die zweite Korrektivkapazität CN2 unter Beobachtung des Ausgangssignals des Verbrauchers oder der an der Ausgangsanschlüssen Out gemessenen Spannung justiert wird.

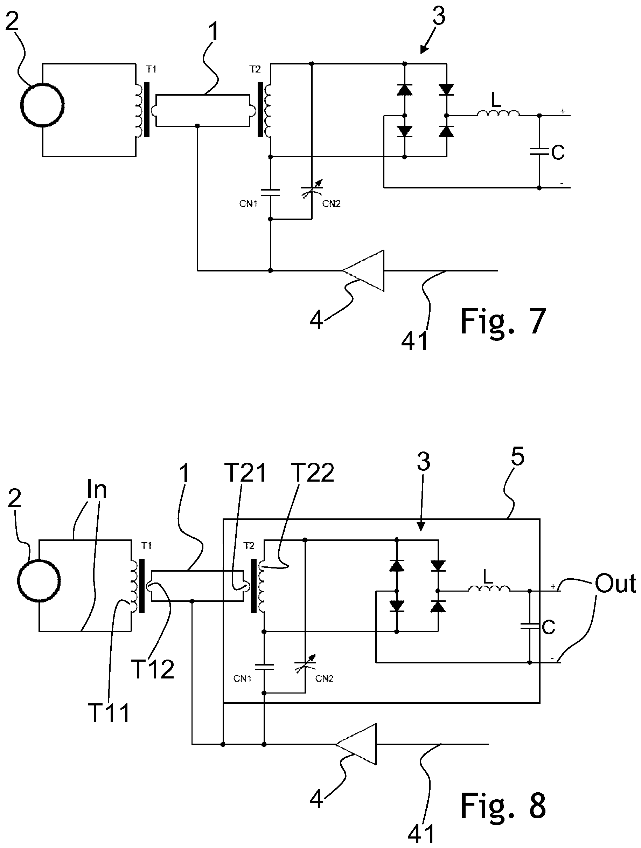

Schließlich wird in der Fig. 8 schematisch eine Abschirmung 5 des zweiten Transformators T2, des Gleichrichters aus der Diodenbrücke 3 und der LC-Schaltung, sowie der Korrektivkapazitäten CN1, CN2 veranschaulicht. Bei der Abschirmung 5 handelt es sich insbesondere um eine Metallplatte, welche oberhalb der Schaltung angeordnet ist und die abgeschirmten Komponenten bedeckt. Die Abschirmung wird ebenfalls an dem Bezugspotential gehalten. Alternativ kann die Abschirmung ebenso geerdet sein, wie die Kurzschlusswindung 1 in der Fig. 5.

### Bezugszeichenliste:

1 Kurzschlusswindung
2 Primärwechselspannung
3 Diodenbrücke
4 Impedanzwandler
41 Impedanzwandler-Eingang
5 Abschirmung
6 Signalausgang
A+, A- Vorverstärkerausgänge
Ab Vorspannverstärker
C Gleichrichter-Kapazität
Cb Vorspannkondensator
CN1 erste Korrektivkapazität
CN2 zweite Korrektivkapazität
D1, D11, D12, D2, D21, D22 Vorspanndiode (Fühlerdiode)
DZ Zenerdiode
E+, E- Vorverstärkereingänge
Ib Konstantstromquelle
In Eingangsanschlüsse
L Gleichrichter-Induktivität
LTP Eingangsdifferenzverstärkerstufe
Out Ausgangsanschlüsse
P1 Potentiometer
Pb Vorspannpotentiometer
Q1, Q11, Q12 erste Verstärkertransistoren
Q2, Q21, Q22 zweite Verstärkertransistoren
Q3, Q3', R3, R3' Spannungsverstärkerstufe, positiv
Q4, Q4', R4, R4' Spannungsverstärkerstufe, negativ
Qb Transistor
R2 Widerstand
Rb Vorspannwiderstand
T1 ersten Transformator
T11 erste Primärwicklung
T12 erste Sekundärwicklung
T2 zweiter Transformator
T21 zweite Primärwicklung
T22 zweite Sekundärwicklung
UA Operationsverstärker
V+, V- Verstärkerspannungsquelle
Vb Spannungsquelle

## Patentansprüche

1. Signalverstärkerschaltung zum Verstärken eines Signals aufweisend:
- zumindest einen ersten Verstärkertransistor (Q1) und zumindest einen zweiten Verstärkertransistor (Q2), wobei der erste Verstärkertransistor (Q1) und der zweite Verstärkertransistor (Q2) in einer Gegentaktschaltung miteinander verbunden sind und von einer Verstärkerspannungsquelle (V+, V-) gespeist werden; und
- eine oder mehrere Vorspanndioden (D1, D2), welche jeweils mit einem zugehörigen Verstärkertransistor (Q1, Q2) thermisch gekoppelt sind, wobei die Vorspanndioden (D1, D2) zur Verminderung oder Vermeidung einer Übernahmeverzerrung in einer Parallelschaltung zu der Verstärkungstransistoren (Q1, Q2) angeordnet sind, um eine Vorspannung bereitzustellen, welche dem Temperaturverhalten der Verstärkertransistoren (Q1, Q2) folgt,
**dadurch gekennzeichnet, dass** die Vorspanndioden (D1, D2) durch eine Präzisions-Konstantstromquelle (Ib) gespeist werden, welche wiederum mittels einer von der Verstärkerspannungsquelle (V+, V-) unabhängigen Spannungsquelle (Vb) versorgt wird.

2. Signalverstärkerschaltung nach Anspruch 1, **dadurch gekennzeichnet, dass** die unabhängige Spannungsquelle (Vb) in Bezug auf die Verstärkungstransistoren (Q1, Q2) als potentialfreie Spannungsquelle (Vb) ausgebildet ist.

3. Signalverstärkerschaltung nach Anspruch 1 oder 2, **dadurch gekennzeichnet, dass** die Vorspanndioden (D1, D2) mittels der unabhängigen Spannungsquelle (Vb) über einen Vorspannverstärker (Ab) gespeist werden.

4. Signalverstärkerschaltung nach Anspruch 3, **dadurch gekennzeichnet, dass** der Vorspannverstärker (Ab) Teil der die Vorspanndioden (D1, D2) speisenden Konstantstromquelle (Ib) ist.

5. Signalverstärkerschaltung nach einem der vorangehenden Ansprüche, **dadurch gekennzeichnet, dass** die Konstantstromquelle (Ib) einstellbar ausgebildet ist.

6. Signalverstärkerschaltung nach einem der vorangehenden Ansprüche, **dadurch gekennzeichnet, dass** die Vorspanndioden (D1, D2) jeweils mit dem zugehörigen Verstärkertransistor (Q1, Q2) in einem gemeinsamen Gehäuse angeordnet sind oder dass die Vorspanndioden (D1 , D2) jeweils an einem Kühlkörper des zugehörigen Verstärkertransistors (Q1, Q2) angeordnet sind.

7. Signalverstärkerschaltung nach einem der vorangehenden Ansprüche, **dadurch gekennzeichnet, dass** der zumindest eine erste Verstärkertransistor (Q1) mehrere in einer ersten Darlingtonschaltung miteinander verbundene erste Verstärkertransistoren (Q1 , Q11 , Q12) umfasst und/oder dass der zumindest eine zweite Verstärkertransistor (Q2) mehrere in einer zweiten Darlingtonschaltung miteinander verbundene zweite Verstärkertransistoren (Q2, Q21, Q22) umfasst.

8. Signalverstärkerschaltung nach einem der vorangehenden Ansprüche, **dadurch gekennzeichnet, dass** sie als eine Audioverstärkerschaltung, insbesondere als eine Audioendstufenschaltung ausgebildet ist.

9. Signalverstärkerschaltung nach einem der vorangehenden Ansprüche, **dadurch gekennzeichnet, dass** die unabhängige Spannungsquelle (UA) aufweist:
- einen eingangsseitigen ersten Transformator (T1) mit einer ersten Primärwicklung und einer ersten Sekundärwicklung; und
- einen mit dem ersten Transformator (T1) verbundenen ausgangsseitigen zweiten Transformator (T2) mit einer zweiten Primärwicklung und einer zweiten Sekundärwicklung, wobei die erste Sekundärwicklung des ersten Transformators (T1) unmittelbar mit der zweiten Primärwicklung des zweiten Transformator (T2) verbunden ist.

10. Signalverstärkerschaltung nach Anspruch 9, **dadurch gekennzeichnet, dass** die erste Sekundärwicklung und/oder die zweite Primärwicklung maximal fünf, vorzugsweise maximal eine, bevorzugt maximal eine halbe Windung aufweist/aufweisen.

11. Signalverstärkerschaltung nach Anspruch 9 oder 10, **dadurch gekennzeichnet, dass** der zweite Transformator (T2) von einer Abschirmung umgeben ist, welche mit einem Anschluss der zweiten Primärwicklung des zweiten Transformators (T2) verbunden ist.

12. Signalverstärkerschaltung nach einem der Ansprüche 9 bis 11, **dadurch gekennzeichnet, dass** ein Anschluss der zweiten Sekundärwicklung (T22) des zweiten Transformators (T2) über eine erste Korrektivkapazität (CN1) und/oder dass ein weiterer Anschluss der zweiten Sekundärwicklung (T22) über eine zweite Korrektivkapazität mit einer Erdung verbunden ist oder an einem Bezugspotential gehalten wird, welcher dem zu verstärkenden Signal folgt.

13. Signalverstärkerschaltung nach Anspruch 12, **dadurch gekennzeichnet, dass** die erste Korrektivkapazität (CN1) und/oder zweite Korrektivkapazität (CN2) einstellbar sind/ist.

14. Signalverstärkerschaltung nach einem der Ansprüche 9 bis 13, **dadurch gekennzeichnet, dass** ein Anschluss der zweiten Primärwicklung des zweiten Transformators (T2) geerdet ist oder dynamisch an einem Bezugspotential gehalten wird, welcher dem zu verstärkenden Signal folgt.

## Claims

1. Signal amplifier circuit for amplifying a signal comprising:
- at least one first amplifier transistor (Q1) and at least one second amplifier transistor (Q2), wherein the first amplifier transistor (Q1) and the second amplifier transistor (Q2) are connected to one another in a push-pull circuit and are fed by an amplifier voltage source (V+, V-); and
- one or more bias diodes (D1, D2) thermally coupled in each case to an associated amplifier transistor (Q1, Q2), wherein the bias diodes (D1, D2) are arranged in a parallel connection with respect to the amplifying transistors (Q1, Q2) in order to reduce or avoid a crossover distortion and in order to provide a bias voltage which follows the thermal behavior of the amplifier transistors (Q1, Q2),
**characterized in that** the bias diodes (D1, D2) are fed by a precision constant current source (Ib), which is fed by a voltage source (UA) independent from the amplifier voltage source (V+, V-).

2. Signal amplifier circuit according to claim 1, **characterized in that** the independent voltage source (Vb) is embodied as a floating voltage source (Vb) in relation to the amplifying transistors (Q1, Q2).

3. Signal amplifier circuit according to claim 1 or 2, **characterized in that** the bias diodes (D1, D2) are fed by means of the independent voltage source (Vb) via a bias amplifier (Ab).

4. Signal amplifier circuit according to claim 3, **characterized in that** the bias amplifier (Ab) is part of the constant-current source (Ib) which feeds the bias diodes (D1, D2) .

5. Signal amplifier circuit according any of the preceding claims, **characterized in that** the constant-current source (Ib) is embodied in an adjustable fashion.

6. Signal amplifier circuit according to any of the preceding claims, **characterized in that** the bias diodes (D1, D2) are arranged in each case with the associated amplifier transistor (Q1, Q2) in a common housing, or **in that** the bias diodes (D1, D2) are arranged in each case on a heat sink of the associated amplifier transistor (Q1, Q2).

7. Signal amplifier circuit according to any of the preceding claims, **characterized in that** the at least one first amplifier transistor (Q1) comprises a plurality of first amplifier transistors (Q1, Q11, Q12) connected to one another in a first Darlington circuit, and/or **in that** the at least one second amplifier transistor (Q2) comprises a plurality of second amplifier transistors (Q2, Q21, Q22) connected to one another in a second Darlington circuit.

8. Signal amplifier circuit according to any of the preceding claims, **characterized in that** it is embodied as an audio amplifier circuit, in particular as an audio output stage circuit.

9. Signal amplifier circuit according to any of the preceding claims, **characterized in that** the independent voltage source (UA) comprises:
- an input-side first transformer (T1) having a first primary winding and a first secondary winding; and
- an output-side second transformer (T2) having a second primary winding and a second secondary winding, said second transformer being connected to the first transformer (T1),
wherein the first secondary winding of the first transformer (T1) is directly connected to the second primary winding of the second transformer (T2).

10. Signal amplifier circuit according to claim 9, **characterized in that** the first secondary winding and/or the second primary winding have/has a maximum of five turns, with preference a maximum of one turn, preferably a maximum of half a turn.

11. Signal amplifier circuit according to claim 9 or 10, **characterized in that** the second transformer (T2) is surrounded by a shield connected to a terminal of the second primary winding of the second transformer (T2).

12. Signal amplifier circuit according to any of claims 9 to 11, **characterized in that** a terminal of the second secondary winding (T22) of the second transformer (T2), via a first corrective capacitance (CN1), and/or **in that** a further terminal of the second secondary winding (T22), via a second corrective capacitance, are/is connected to ground or kept at a reference potential which follows the signal to be amplified.

13. Signal amplifier circuit according to claim 12, **characterized in that** the first corrective capacitance (CN1) and/or the second corrective capacitance (CN2) are/is adjustable.

14. Signal amplifier circuit according to any of claims 9 to 13, **characterized in that** a terminal of the second primary winding of the second transformer (T2) is grounded or is dynamically kept at a reference potential which follows the signal to be amplified.

## Revendications

1. Circuit amplificateur de signal pour l'amplification d'un signal, comprenant :
- au moins un premier transistor amplificateur (Q1) et au moins un deuxième transistor amplificateur (Q2), dans lequel le premier transistor amplificateur (Q1) et le deuxième transistor amplificateur (Q2) sont reliés entre eux dans un circuit push-pull et sont alimentés par une source de tension d'amplificateur (V+, V-) ; et
- une ou plusieurs diodes de polarisation (D1, D2) qui sont couplées chacune thermiquement à un transistor amplificateur (Q1, Q2) correspondant, dans lequel les diodes de polarisation (D1, D2) sont disposées dans un circuit parallèle aux transistors amplificateurs (Q1, Q2), pour réduire ou prévenir une distorsion de recoupement, afin de fournir une tension de polarisation qui suit le comportement en température des transistors amplificateurs (Q1, Q2),
**caractérisé en ce que** les diodes de polarisation (D1, D2) sont alimentées par une source de courant constant de précision (Ib), qui est elle-même alimentée par une source de tension (Vb) indépendante de la source de tension d'amplificateur (V+, V-).

2. Circuit amplificateur de signal selon la revendication 1, **caractérisé en ce que** la source de tension indépendante (Vb) est conçue comme une source de tension libre de potentiel (Vb) par rapport aux transistors d'amplification (Q1, Q2).

3. Circuit amplificateur de signal selon la revendication 1 ou 2, **caractérisé en ce que** les diodes de polarisation (D1, D2) sont alimentées au moyen de la source de tension indépendante (Vb) par l'intermédiaire d'un amplificateur de polarisation (Ab).

4. Circuit amplificateur de signal selon la revendication 3, **caractérisé en ce que** l'amplificateur de polarisation (Ab) fait partie de la source de courant constant (Ib) qui alimente les diodes de polarisation (D1, D2).

5. Circuit amplificateur de signal selon l'une des revendications précédentes, **caractérisé en ce que** la source de courant constant (Ib) est conçue de façon à être réglable.

6. Circuit amplificateur de signal selon l'une des revendications précédentes, **caractérisé en ce que** les diodes de polarisation (D1, D2) sont disposées chacune, avec le transistor amplificateur (Q1, Q2) correspondant, dans un boîtier commun ou **en ce que** les diodes de polarisation (D1, D2) sont disposées chacune au niveau d'un radiateur du transistor amplificateur (Q1, Q2) correspondant.

7. Circuit amplificateur de signal selon l'une des revendications précédentes, **caractérisé en ce que** l'au moins un premier transistor amplificateur (Q1) comprend plusieurs premiers transistors amplificateurs (Q1, Q11, Q12) reliés entre eux dans un premier circuit de Darlington et/ou **en ce que** l'au moins un deuxième transistor amplificateur (Q2) comprend plusieurs deuxièmes transistors amplificateurs (Q2, Q21, Q22) reliés entre eux dans un deuxième circuit de Darlington.

8. Circuit amplificateur de signal selon l'une des revendications précédentes, **caractérisé en ce qu'**il est conçu comme un circuit amplificateur audio, plus particulièrement comme un circuit d'étage final audio.

9. Circuit amplificateur de signal selon l'une des revendications précédentes, **caractérisé en ce que** la source de tension indépendante (UA) comprend :
- un premier transformateur côté entrée (T1) avec un premier enroulement primaire et un premier enroulement secondaire ; et
- un deuxième transformateur côté sortie (T2), relié avec le premier transformateur (T1), avec un deuxième enroulement primaire et un deuxième enroulement secondaire, dans lequel le premier enroulement secondaire du premier transformateur (T1) est relié directement avec le deuxième enroulement primaire du deuxième transformateur (T2).

10. Circuit amplificateur de signal selon la revendication 9, **caractérisé en ce que** le premier enroulement secondaire et/ou le deuxième enroulement primaire comprennent maximum cinq, de préférence maximum un, de préférence maximum un demi-enroulement.

11. Circuit amplificateur de signal selon la revendication 9 ou 10, **caractérisé en ce que** le deuxième transformateur (T2) est entouré d'un blindage, qui est relié avec un raccord du deuxième enroulement primaire du deuxième transformateur (T2).

12. Circuit amplificateur de signal selon l'une des revendications 9 à 11, **caractérisé en ce qu'**un raccord du deuxième enroulement secondaire (T22) du deuxième transformateur (T2) est relié avec une mise à la terre par l'intermédiaire d'un premier condensateur correctif (CN1) et/ou **en ce qu'**un autre raccord du deuxième enroulement secondaire (T22) est relié avec une mise à la terre par l'intermédiaire d'un deuxième condensateur correctif ou est maintenu à un potentiel de référence qui suit le signal à amplifier.

13. Circuit amplificateur de signal selon la revendication 12, **caractérisé en ce que** le premier condensateur correctif (CN1) et/ou le deuxième condensateur correctif (CN2) est réglable.

14. Circuit amplificateur de signal selon l'une des revendications 9 à 13, **caractérisé en ce qu'**un raccord du deuxième enroulement primaire du deuxième transformateur (T2) est mis à la terre ou maintenu de manière dynamique à un potentiel de référence qui suit le signal à amplifier.
